# EUROPEAN PATENT SPECIFICATION

(11) **EP 3 573 114 B1**
(45) Date of publication and mention of the grant of the patent: **21.10.2026**
(21) Application number: 19175494.4
(22) Date of filing: 20.05.2019
(51) Int. Cl.: H10H 20/857, H10H 20/01, H10H 20/831, H10H 20/858

(54) **SEMICONDUCTOR LIGHT EMITTING APPARATUS HAVING MULTIPLE CONDUCTIVE BONDING LAYER ELEMENTS AND ITS MANUFACTURING METHOD**
LICHTEMITTIERENDE HALBLEITERVORRICHTUNG MIT MEHREREN LEITFÄHIGEN VERBINDUNGSSCHICHTELEMENTEN UND DEREN HERSTELLUNGSVERFAHREN
APPAREIL ÉLECTROLUMINESCENT SEMICONDUCTEUR DOTÉ DE PLUSIEURS ÉLÉMENTS DE COUCHE DE LIAISON CONDUCTRICE ET SON PROCÉDÉ DE FABRICATION

(30) Priority: 24.05.2018 JP 2018099340
(43) Date of publication of application: 27.11.2019
(73) Proprietor: STANLEY ELECTRIC CO., LTD., Tokyo 153-8636 (JP)
(72) Inventor: SHINNO, Kazuhisa, Tokyo, 153-8636 (JP)
(74) Representative: Emde, Eric

(56) References cited:
- EP-A1- 2 207 210
- EP-A1- 2 219 232
- EP-A2- 1 531 492
- US-A1- 2002 190 260
- US-A1- 2010 117 114
- US-A1- 2010 219 444
- US-A1- 2010 227 421
- US-A1- 2015 287 900

## Description

### BACKGROUND

### Field

The present invention relates to a semiconductor light emitting apparatus having a semiconductor light emitting element mounted on a substrate and its manufacturing method.

### Description of the Related Art

Generally, in a semiconductor light emitting apparatus, a light emitting diode (LED) element is bonded by a high heat-dissipating AuSn eutectic bonding layer to a submount substrate.

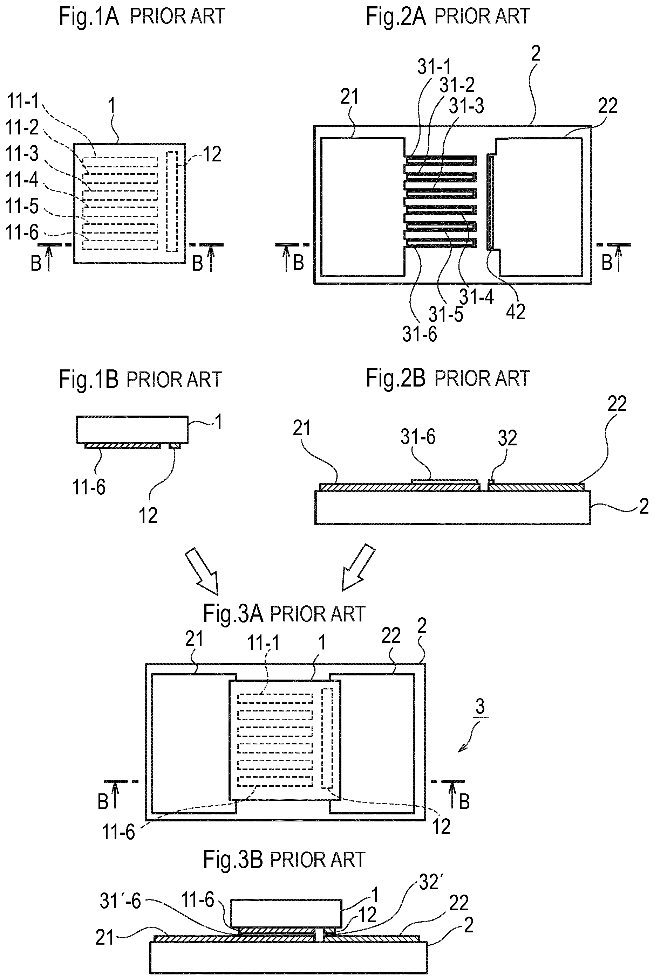

A prior art method for manufacturing a semiconductor light emitting apparatus will be explained now with reference to Figs. 1A, 1B, 2A, 2B, 3A and 3B.

First, referring to Fig. 1A and Fig. 1B which is a cross-sectional view taken along the line B-B in Fig. 1A, an LED element 1 has slender p-side electrodes 11-1, 11-2, ···, 11-6 electrically connected to a p-type semiconductor region (not shown) and a slender n-side electrode 12 electrically-connected to an n-type semiconductor region (not shown). In this case, each of the electrodes 11-1, 11-2, ···, 11-6 and 12 viewed from the top has a rectangular shape with a short side and a long side twice or more as long as the short side. Thus, the heat resistance can be decreased and the fluctuation of a forward voltage can be suppressed. Also, since the p-side electrodes 11-1, 11-2, ···, 11-6 are broadly spread on the bottom of the LED element 1, currents from the p-side electrodes 11-1, 11-2, ···, 11-6 can be spread through an entire active region (not shown) within the LED element 1 to the n-side electrode 12, which can improve the light emitting efficiency and make the light emitting distribution uniform. Note that bonding layers (not shown) including an uppermost Au layer are formed on the p-side electrodes 11-1, 11-2, ···, 11-6 and the n-side electrode 12 by a plating process or a sputtering process.

On the other hand, referring to Fig. 2A and Fig. 2B which is a cross-sectional view taken along the line B-B in Fig. 2A, a submount substrate 2 made of AlN, for example, has a p-side wiring pattern layer 21 and an n-side wiring pattern layer 22. The p-side wiring pattern layer 21 has AuSn layers 31-1, 31-2, ···, 31-6 corresponding to the p-side electrodes 11-1, 11-2, ···, 11-6, respectively, of the LED element 1, and the n-side wiring pattern layer 22 has an AuSn layer 32 corresponding to the n-side electrode 12 of the LED element 1. Note that bonding layers (not shown) including an uppermost Au layer are formed on the p-side wiring pattern layer 21 and the n-side wiring pattern layer 22, and pads (not shown) are formed thereon.

Finally, referring to Fig. 3A and Fig. 3B which is a cross-sectional view taken along the line B-B in Fig. 3A, the LED element 1 of Figs. 1A and 1B is faced down in a thermal-pressuring process on the submount substrate 2 of Figs. 2A and 2B, so that the uppermost Au layers of the AuSn layer 31-1, 31-2, ···, 31-6 and 32 of the submount substrate 2 are eutectic with the uppermost Au layers of the p-side electrodes 11-1, 11-2, ···, 11-6 and the n-side electrode 12 of the LED element 1 to form AuSn eutectic bonding layer 31' -1, 31' -2, ···, 31' -6 and 32' . As a result, the p-side electrodes 11-1, 11-2, ···, 11-6 of the LED element 1 are electrically connected to the p-side wiring pattern layer 21 of the submount substrate 2, and the n-side electrode 12 of the LED element 1 is electrically connected to the n-side wiring pattern layer 22 of the submount substrate 2. Thus, the LED element 1 is bonded by the AuSn eutectic bonding layer 31' -1, 31' -2, ···, 31' -6 and 32' to the submount substrate 2, completing a semiconductor light emitting apparatus 3.

In the semiconductor light emitting apparatus 3 of Figs. 3A and 3B, however, the AuSn eutectic bonding layer 31' -1, 31' -2, ···, 31' -6 and 32' has the following bonding defects.

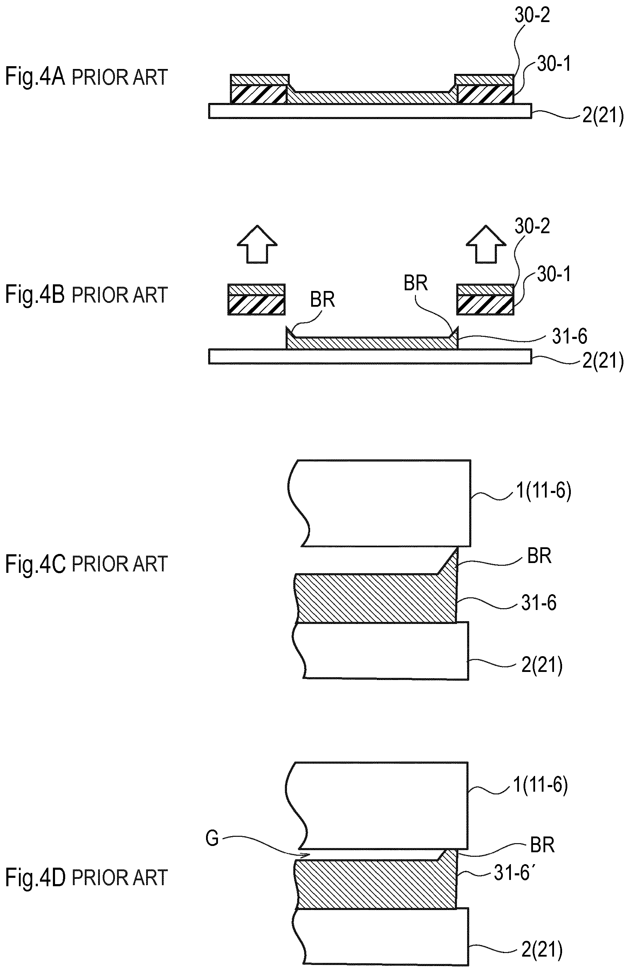

The AuSn layers 31-1, 31-2, ···, 31-6 and 32 of Figs. 2A and 2B are usually formed by a lift-off process. That is, as illustrated in Fig. 4A, a photoresist pattern 30-1 for forming the AuSn layers 31-1, 31-2, ···, 31-6 and 32 is formed by a photolithography process on a submount substrate 2 (the p-side wiring pattern layer 21), and then, an AuSn layer 30-2 is deposited on the entire surface by a sputtering process or an evaporating process. Then, as illustrated in Fig. 4B, the photoresist pattern layer 30-1 is removed to form the AuSn layers 31-1, 31-2, ···, 31-6 and 32. In this case, however, when the photoresist pattern layer 30-1 is removed to rupture the AuSn layer 30-2, burrs BR would be created on the edges of the AuSn layers 31-1, 31-2, ···, 31-6 and 32.

Also, the LED element 1 is bonded on the submount substrate 2 (the p-side wiring pattern layer 21) having the burrs BR as illustrated in Fig. 4C, and then, a thermal-pressuring process is carried out, so that only a top part of the burrs BR is dissolved as illustrated in Fig. 4D. However, as there is a pressure gradient of the LED element 1 (the p-side electrode 11-6), the amount of the AuSn eutectic bonding layer 31'-1, 31'-2, ···, 31'-6 and 32' would be uneven. As a result, the AuSn eutectic bonding layer 31' -1, 31' -2, ···, 31' -6 and 32' would become uneven to create a large gap G between the LED element 1 (the p-side electrode 11-6) and the submount substrate 2 (the p-side wiring pattern layer 21). That is, only a part of the LED element 1 (the p-side electrode 11-6) can be in contact with the submount substrate 2 (the p-side wiring pattern layer 21), so that the bonding area therebetween would be small. Even when the LED element 1 (the p-side electrode 11-6) is completely in contact with the submount substrate 2 (the p-side wiring pattern layer 21), AuSn would be exposed to a high temperature due to the presence of the burrs BR, and would be thermally oxidized before the burrs BR are dissolved, which would be an obstacle in a eutectic reaction. Thus, a defective bonding would happen between the LED element 1 and the submount substrate 2 after the thermal-pressuring process.

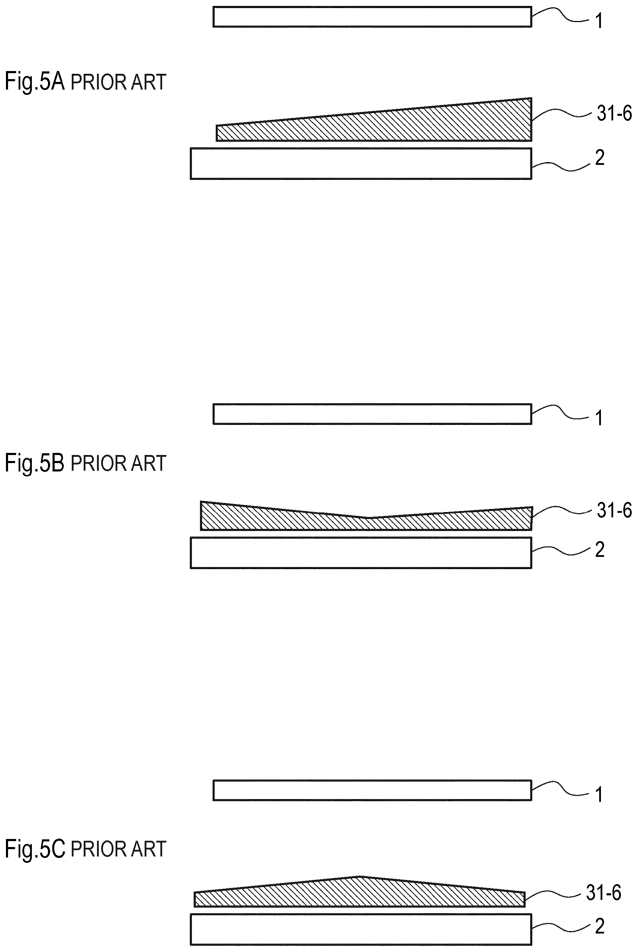

Further, since the p-side electrodes 11-1, 11-2, ···, 11-6 and the n-side electrode 12 and their corresponding AuSn layers 31-1, 31-2, ···, 31-6 and 32 are slender, the AuSn layers 31-1, 31-2, ···, 31-6 and 32 would be sloped lengthwise as illustrated in Fig. 5A, or the center portions of the AuSn layers 31-1, 31-2, ···, 31-6 and 32 would be deeply concave as illustrated in Fig. 5B, or the center portions of the AuSn layers 31-1, 31-2, ···, 31-6 and 32 would be highly convex as illustrated in Fig. 5C. In any case, the bonding area between the LED element 1 and the submount substrate 2 would be decreased, so that a defective bonding also would happen between the LED element 1 and the submount substrate 2 after the thermal-pressuring process.

The above-described defective bonding would invite the fluctuation of the heat resistance and the fluctuation of the forward voltage, which would invite irregular light emitting characteristics.

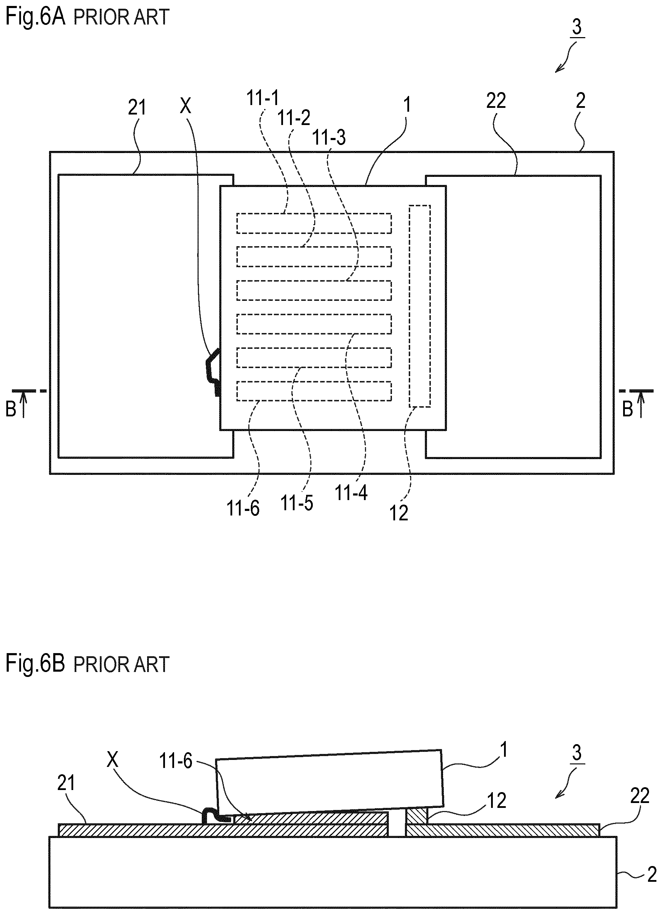

Still further, when the burrs BR are created on the edges of the AuSn layers 31-1, 31-2, ···, 31-6 and 32, or the AuSn layers 31-1, 31-2, ···, 31-6 and 32 are sloped lengthwise, deeply concave or highly convex, the AuSn eutectic bonding layer 31' -1, 31' -2, ···, 31' -6 and 32' after the thermal-pressuring process would protrude from the LED element 1 as illustrated by X in Figs. 6A and 6B. Particularly, when the AuSn layers 31-1, 31-2, ···, 31-6 and 32 are sloped lengthwise, the LED element 1 would be sloped as illustrated in Fig. 6B. As a result, the LED element 1 would be short-circuited to the wiring pattern layer 21 or 22 of the submount substrate 2, so that the semiconductor light emitting apparatus 3 would not operate.

US 2015 287900 A1 discloses a method of manufacturing a light-emitting diode (LED) chip including forming an LED on a first substrate, the LED including an N-type and a P-type semiconductor layer, the LED being formed to expose surfaces of the N-type and P-type semiconductor layers, forming bumps respectively electrically connected to the N-type and P-type semiconductor layers, forming electrode pads corresponding to the bumps on a second substrate, aligning the LED chip and the second substrate so that the bumps respectively correspond to the electrode pads, and increasing a temperature of the bumps to a first temperature, applying a pressure to the first and second substrates, and increasing the temperature of the bumps to a second temperature for a first time period while maintaining the pressure, and maintaining the second temperature from the first time period to a second time period while maintaining the pressure, and then releasing the pressure and cooling the bumps.

EP 1 531 492 A2 discloses a semiconductor device and its manufacturing method. A confronting surface of a substrate faces a first surface of a semiconductor element. Extension layers are formed on the substrate at positions facing electrodes on the semiconductor element. A levee film is disposed on one of the confronting surface and the first surface. Openings are formed through the levee film. Connection members which are filled but not completely filled in the openings connect the electrodes and the extension layers.

US 2010 227421 A1 discloses a compliant bonding structure which is disposed between a semiconductor device and a mount. When the semiconductor light emitting device is attached to the mount, for example by providing ultrasonic energy to the semiconductor light emitting device, the compliant bonding structure collapses to partially fill a space between the semiconductor light emitting device and the mount.

EP 2 219 232 A1 discloses semiconductor light-emitting devices, in which a light-emitting layer is formed on one surface of a substrate, and an n-side electrode and a p-side electrode are formed over the same surface of the substrate as the light-emitting layer, and wherein heat generated by a semiconductor light-emitting element needs to be dissipated to a submount.

EP 2 207 210 A1 discloses a semiconductor light emitting device, in which a light emitting layer is formed on one surface of a conductive substrate, and an n-type electrode and a p-type electrode are formed on the same side as the light emitting layer.

US 2010 117114 A1 discloses a light-emitting apparatus has a light-emitting device and a supporting board. The light-emitting device has a pair of n-electrodes with a p-electrode therebetween, on the same plane. The supporting board includes an insulating substrate on which positive and negative electrodes are formed, opposing to the p- and n-electrodes of the light-emitting device, respectively. Bonding members bond the p- and n-electrodes with the positive and negative electrodes, respectively. The positive electrode on the supporting board is formed within the width region of the p-electrode and narrower in width than the width of the p-electrode, in a cross-section along a line extending through the pair of n-electrodes. The negative electrodes oppose to the n-electrodes, respectively, with the same widths, or with that side face of each of the negative electrodes which faces the positive electrode being retracted outwardly from that side face of each of the n-electrodes which faces the p-electrode.

US 2002 190260 A1 discloses a light emitting device which includes a light emitting region and a reflective contact separated from the light emitting region by one or more layers.

US 2010 219444 A1 discloses a manufacturing method of a mounting part of a semiconductor light emitting element. The a manufacturing method comprises; preparing a semiconductor light emitting element including an electrode which has a surface, and a board which has a surface; forming a plurality of bump material bodies on at least one of the surface of the electrode and the surface of the board by shaping bump material into islands, wherein the bump material is paste in which metal particles are dispersed, a top surface and a bottom surface of the bump material bodies have different areas, and the top surface is practically flat; solidifying the bump material bodies by thermally processing the bump material bodies; and fixing the semiconductor light emitting element and the board through the bumps.

### SUMMARY

The presently disclosed subject matter seeks to solve one or more of the above-described problems.

According to an aspect of the present invention, a semiconductor light emitting apparatus is provided as set forth in claim 1.

According to another aspect of the present invention, a method for manufacturing a semiconductor light emitting apparatus is provided as set forth in claim 5.

Preferred embodiments of the present invention are the object of the appended dependent claims.

According to the presently disclosed subject matter, a bonding defect between the semiconductor light emitting element and the substrate can be substantially eliminated.

### BRIEF DESCRIPTION OF THE DRAWINGS

The above and other advantages and features of the presently disclosed subject matter will be more apparent from the following description of certain embodiments, some of which are embodiments of the present invention as defined by the appended claims, while others are illustrative embodiments not forming part of the present invention as claimed but useful for understanding its context, compared with the prior art, taken in conjunction with the accompanying drawings, wherein:
Figs. 1A, 2A and 3A are top views for explaining a prior art method for manufacturing a semiconductor light emitting apparatus;
Figs. 1B, 2B and 3B are cross-sectional views taken along the line B-B of Figs. 1A, 2A and 3A, respectively;
Figs. 4A, 4B, 4C and 4D are cross-sectional views for explaining a problem caused by the prior art method as illustrated in Figs. 1A, 1B, 2A, 2B, 3A and 3B;
Figs. 5A, 5B and 5C are cross-sectional views for explaining another problem caused by the prior art method as illustrated in Figs. 1A, 1B, 2A, 2B, 3A and 3B;
Fig. 6A is a top view for explaining still another problem caused by the prior art method as illustrated in Figs. 1A, 1B, 2A, 2B, 3A and 3B;
Fig. 6B is a cross-sectional view taken along the line B-B of Fig. 6A;
Figs. 7A, 8A and 9A are top views for explaining a first embodiment, not forming part of the present invention as claimed but useful for understanding its context, of the method for manufacturing a semiconductor light emitting apparatus according to the presently disclosed subject matter;
Figs. 7B, 8B and 9B are cross-sectional views taken along the line B-B of Figs. 7A, 8A and 9A, respectively;
Figs. 10A, 10B, 10C and 10D are cross-sectional views for explaining an effect caused by the method as illustrated in Figs. 7A, 7B, 8A, 8B, 9A and 9B;
Figs. 11A, 11B and 11C are cross-sectional views for explaining another effect caused by the method as illustrated in Figs. 7A, 7B, 8A, 8B, 9A and 9B;
Figs. 12A and 12B are a top view and a cross-sectional view illustrating a modification, in accordance with the present invention as claimed, of the submount substrate of Figs. 8A and 8B;
Figs. 13A, 13B and 13C are cross-sectional views for explaining a method, in accordance with the present invention as claimed, for manufacturing the submount substrate of Figs. 12A and 12B;
Figs. 14A, 15A and 16A are top views for explaining a second embodiment, not forming part of the present invention as claimed but useful for understanding its context, of the method for manufacturing a semiconductor light emitting apparatus according to the presently disclosed subject matter;
Figs. 14B, 15B and 16B are cross-sectional views taken along the line B-B of Figs. 14A, 15A and 16A, respectively;
Fig. 17A is a top view for explaining an effect caused by the method as illustrated in Figs. 14A, 14B, 15A, 15B, 16A and 16B;
Fig. 17B is a cross-sectional view taken along the line B-B of Fig. 17A;
Fig. 18A is a top view for explaining an effect caused by a comparative example;
Fig. 18B is a cross-sectional view taken along the line B-B of Fig. 18A;
Figs. 19A and 19B are a top view and a cross-sectional view illustrating a modification, in accordance with the present invention as claimed, of the submount substrate of Figs. 15A and 15B; and
Figs. 20A and 20B are cross-sectional views for illustrating a modification of the AuSn layers of Figs. 7A and 8B.

### DETAILED DESCRIPTION OF EXEMPLARY EMBODIMENTS

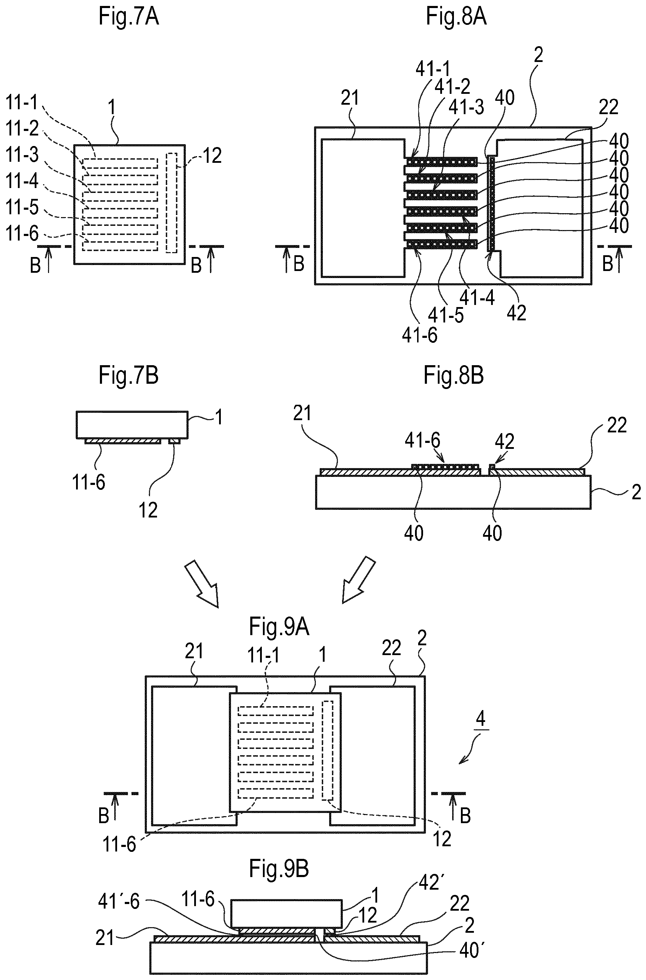

A first embodiment, not defining in itself the present invention as claimed but useful for understanding its context, of the method for manufacturing a semiconductor light emitting apparatus will be explained now with reference to Figs. 7A, 7B, 8A, 8B, 9A and 9B.

First, referring to Fig. 7A and Fig. 7B which is a cross-sectional view taken along the line B-B in Fig. 7A, an LED element 1 the same as illustrated in Figs. 1A and 1B is provided.

On the other hand, referring to Fig. 8A and Fig. 8B which is a cross-sectional view taken along the line B-B in Fig. 8A, a submount substrate 2 made of AIN, for example, has a p-side wiring pattern layer 21 and an n-side wiring pattern layer 22. The p-side wiring pattern layer 21 has AuSn layers 41-1, 41-2, ···, 41-6 corresponding to the p-side electrodes 11-1, 11-2, ···, 11-6, respectively, of the LED element 1, and the n-side wiring pattern layer 22 has an AuSn layer 42 corresponding to the n-side electrode 12 of the LED element 1. Each of the AuSn layers 41-1, 41-2, ···, 41-6 and 42 is constructed by a series of about 1 to 5 µ m thick discrete AuSn layer elements 40 which are one-dimensionally arranged. For example, each of the AuSn layer elements 40 is square viewed from the top, and has a side whose length is the same as the short side of the electrodes 11-1, 11-2, ···, 11-6 and 12 of the LED element 1. In this case, the spacing between the AuSn layer elements 40 is preferably as small as possible.

Finally, referring to Fig. 9A and Fig. 9B which is a cross-sectional view taken along the line B-B in Fig. 9A, the LED element 1 of Figs. 7A and 7B is faced down in a thermal-pressuring process on the submount substrate 2 of Figs. 8A and 8B, so that the uppermost Au layers of the AuSn layer 41-1, 41-2, ···, 41-6 and 42 of the submount substrate 2 are eutectic bonded with the uppermost Au layers of the p-side electrodes 11-1, 11-2, ···, 11-6 and the n-side electrode 12 of the LED element 1 to form AuSn eutectic bonding layers 41' -1, 41' -2, ···, 41' -6 and 42' each formed by multiple AuSn eutectic layer elements 40' . As a result, the p-side electrodes 11-1, 11-2, ···, 11-6 of the LED element 1 are electrically connected to the p-side wiring pattern layer 21 of the submount substrate 2, and the n-side electrode 12 of the LED element 1 is electrically connected to the n-side wiring pattern layer 22 of the submount substrate 2. Thus, the LED element 1 is bonded by the AuSn eutectic bonding layers 41' -1, 41' -2, ···, 41' -6 and 42' to the submount substrate 2, completing a semiconductor light emitting apparatus 4.

In the semiconductor light emitting apparatus 4 of Figs. 9A and 9B, however, the AuSn eutectic bonding layers 41' -1, 41' -2, ···, 41' -6 and 42' can avoid bonding defects.

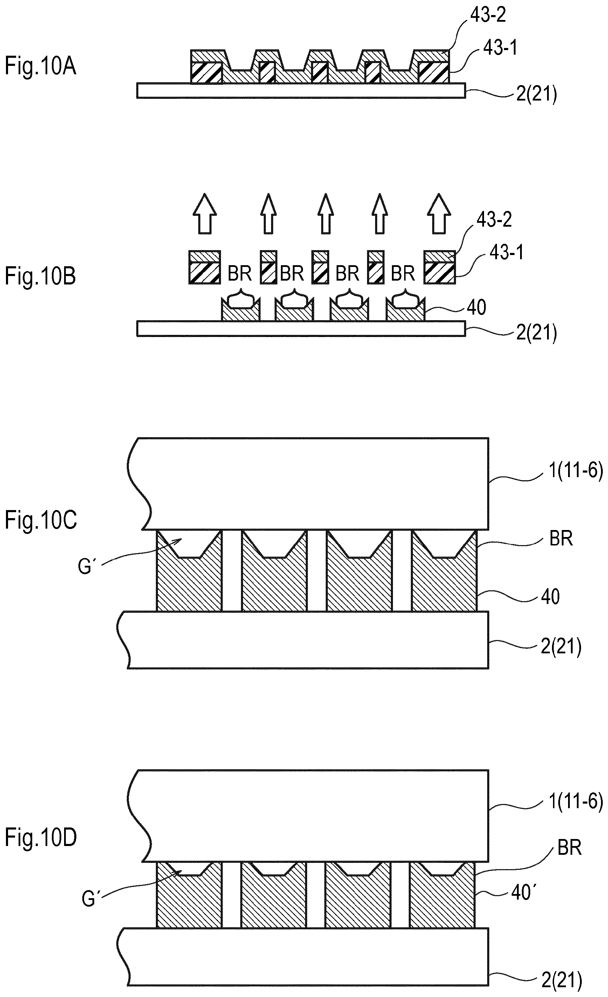

The AuSn layer elements 40 of the AuSn layers 41-1, 41-2, ···, 41-6 and 42 of Figs. 8A and 8B are formed by a lift-off process. That is, as illustrated in Fig. 10A, a photoresist pattern 43-1 for forming the AuSn layers 41-1, 41-2, ···, 41-6 and 42 is formed by a photo lithography process on a submount substrate 2 (the p-side wiring pattern layer 21), and then, an about 1 to 5 µ m thick AuSn layer 43-2 is deposited on the entire surface by a sputtering process or an evaporating process. Then, as illustrated in Fig. 10B, the photoresist pattern layer 43-1 is removed to form the AuSn layer elements 40 of the AuSn layers 41-1, 41-2, ···, 41-6 and 42. Even in this case, when the photoresist pattern layer 43-1 is removed to rupture the AuSn layer 43-2, burrs BR would be created on the edges of the AuSn layer elements 40 of the AuSn layers 41-1, 41-2, ···, 41-6 and 42.

Also, the LED element 1 is bonded on the submount substrate 2 (the p-side wiring pattern layer 21) having the burrs BR as illustrated in Fig. 10C, and then, a thermal-pressuring process is carried out, so that only a top part of the burrs BR is dissolved as illustrated in Fig. 10D. Also, as there is a pressure gradient of the LED element 1 (the p-side electrode 11-6), the amount of the AuSn eutectic bonding layer elements 40' would be uneven. As a result, the AuSn eutectic layer elements 40' of the AuSn eutectic bonding layer 41' -1, 41' -2, ···, 41' -6 and 42' would become uneven to create a small gap G' between the LED element 1 and the submount substrate 2. That is, only a part of the LED element 1 (the p-side electrode 11-6) can be in contact with the submount substrate 2, so that the bonding area therebetween would be small. Even when the LED element 1 is completely in contact with the submount substrate 2, AuSn would be exposed to a high temperature due to the presence of the burrs BR, and thermally oxidized before the burrs BR are dissolved, which would be an obstacle in a eutectic reaction. However, since each of the AuSn layer elements 40' of Fig. 10C is much smaller than the AuSn layer 31-1, 31-2, ···, 31-6 and 32 of Fig. 4C, the gap G' of Fig. 10D is much smaller than the gap G of Fig. 4D. Therefore, the unbonded AuSn eutectic bonding layer elements 40' can be decreased to substantially increase the bonding area of the AuSn eutectic bonding layer elements 40' . Thus, a defective bonding would hardly happen between the LED element 1 and the submount substrate 2 after the thermal-pressuring process.

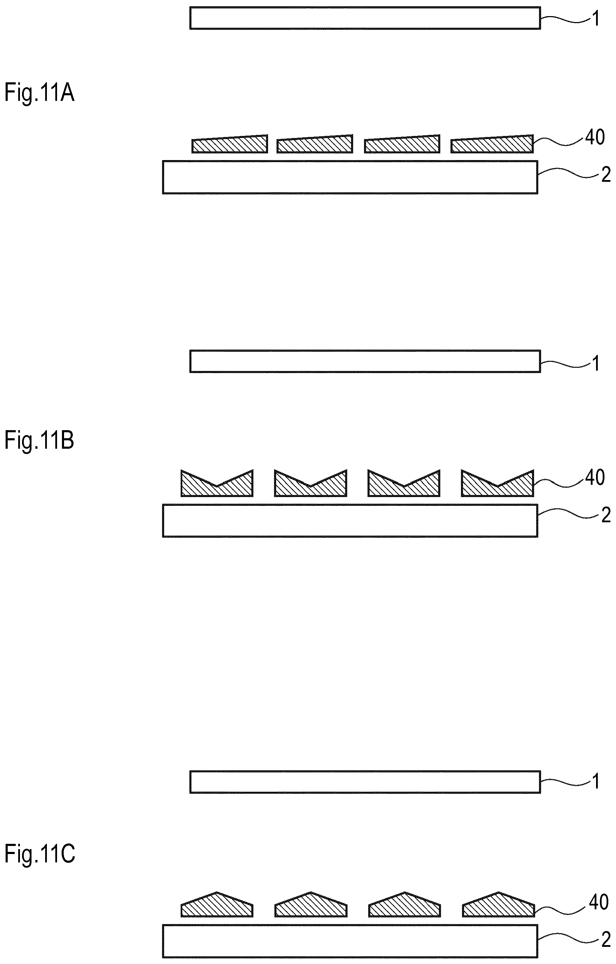

Further, although the p-side electrodes 11-1, 11-2, ···, 11-6 and the n-side electrode 12 are slender, since the AuSn layer elements 40 are short, the AuSn layer elements 40 would be not sloped lengthwise as illustrated in Fig. 11A, or the center portions of the AuSn layer elements 40 would be shallowly concave as illustrated in Fig. 11B, or the center port ions of the AuSn layer elements 40 would be slightly convex as illustrated in Fig. 11C. In any case, the bonding area between the LED element 1 and the submount substrate 2 would be increased, so that a defective bonding would hardly happen between the LED element 1 and the submount substrate 2 after the thermal-pressuring process.

Thus, the fluctuation of the heat resistance and the fluctuation of the forward voltage can be improved, which would also improve the light emitting characteristics.

Still further, since the burrs BR created on the edges of the AuSn layers 41-1, 41-2, ···, 41-6 and 42 are small, or the AuSn layers 41-1, 41-2, ···, 41-6 and 42 are not sloped lengthwise, shallowly concave or slightly convex, the AuSn eutectic bonding layers 41' -1, 41' -2, ···, 41' -6 and 42' after the thermal-pressuring process would hardly be protruded from the LED element 1. In addition, since the burrs BR of the AuSn layers 41-1, 41-2, ···, 41-6 and 42 are small, the LED element 1 would not be sloped. As a result, the LED element 1 would not be short-circuited to the p-side wiring pattern layer 21 or 22 of the submount substrate 2, so that the semiconductor light emitting apparatus 4 would operate.

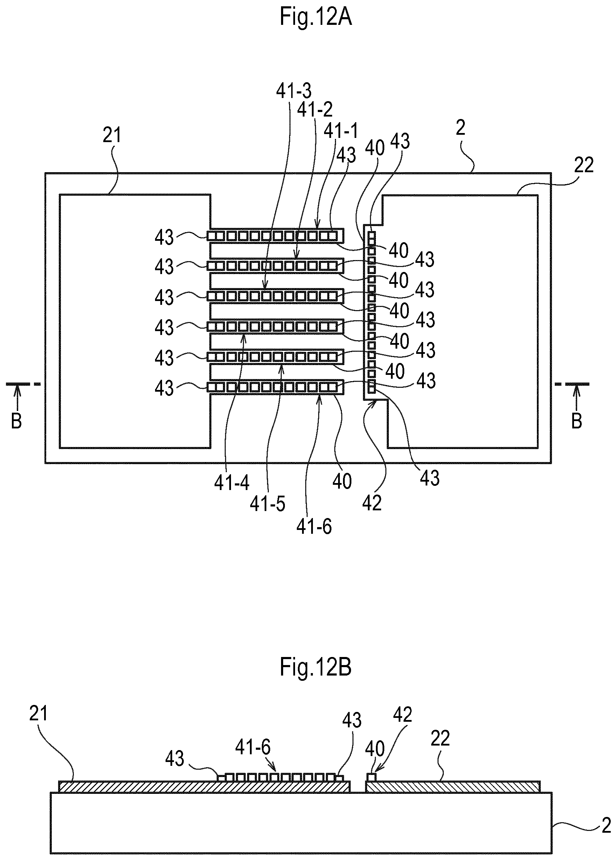

Fig. 12A is a top view illustrating a modification, in accordance with the present invention, of the submount substrate 2 of Figs. 8A and 8B, and Fig. 12B is a cross-sectional view taken along the line B-B in Fig. 12A.

In Figs. 12A and 12B, AuSn-phobic Cr layers 43 that lack an affinity to AuSn in order to repel AuSn are provided in contact with ends of the series of the AuSn layer elements 40. Therefore, in a thermal-pressuring process, the AuSn eutectic bonding layers 41' -1, 41' -2, ···, 41' -6 and 42' move away from the Cr layers 43, thus surely preventing the AuSn eutectic bonding layers 41' -1, 41' -2, ···, 41' -6 and 42' from protruding from the LED element 1 after the thermal-pressuring process.

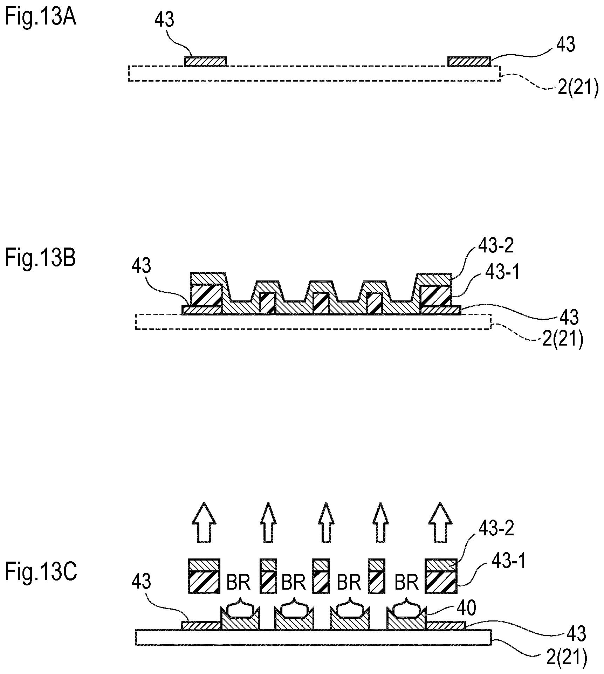

The Cr layers 43 are formed before the formation of the AuSn layer elements 40. That is, as illustrated in Fig. 13A, an about 0.1 µ m thick Cr layer 43 is formed on the p-side wiring pattern layers 21 and 22 of the submount substrate 2 by a plating process and a photolithography and etching process. After that, the AuSn layer elements 40 of the AuSn layers 41-1, 41-2, ···, 41-6 and 42 are formed by a lift-off process. That is, as illustrated in Fig. 13B, a photoresist pattern 43-1 for forming the AuSn layers 41-1, 41-2, ···, 41-6 and 42 is formed by a photolithography process on a submount substrate 2 (the p-side wiring pattern layer 21), and then, an about 1 to 5 µ m thick AuSn layer 43-2 is deposited on the entire surface by a sputtering process or a vacuum depositing process. Then, as illustrated in Fig. 13C, the photoresist pattern layer 43-1 is removed to form the AuSn layer elements 40 of the AuSn layers 41-1, 41-2, ···, 41-6 and 42. Even in this case, when the photoresist pattern layer 43-1 is removed to rupture the AuSn layer 43-2, small burrs BR would be created on the edges of the AuSn layer elements 40 of the AuSn layers 41-1, 41-2, ···, 41-6 and 42.

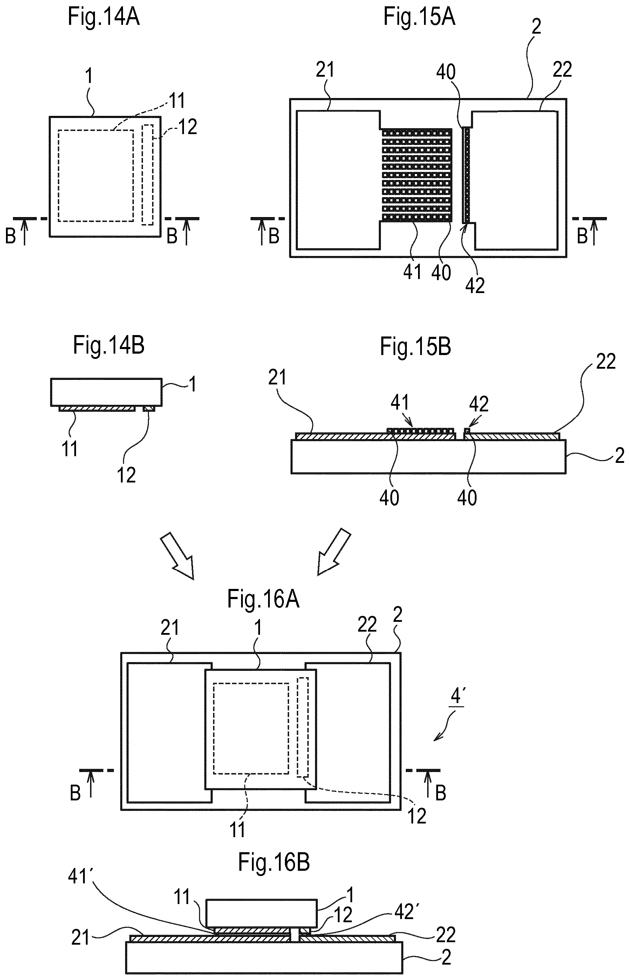

A second embodiment, not defining in itself the present invention as claimed but useful for understanding its context, of the method for manufacturing a semiconductor light emitting apparatus will be explained now with reference to Figs. 14A, 14B, 15A, 15B, 16A and 16B.

First, referring to Fig. 14A and Fig. 14B which is a cross-sectional view taken along the line B-B in Fig. 14A, one broad p-side electrode 11 is provided instead of the p-side electrodes 11-1, 11-2, ···, 11-6 of Figs. 7A and 7B.

On the other hand, referring to Fig. 15A and Fig. 15B which is a cross-sectional view taken a long the line B-B in Fig. 8A, provided on the p-side wiring pattern layer 21 is an AuSn layer 41 corresponding to the p-side electrode 11 of the LED element 1. The AuSn layer 41 is constructed by about 1 to 5 µ m thick discrete AuSn layer elements 40 which are two-dimensionally arranged. Also, in this case, each of the AuSn layer elements 40 is square viewed from the top, and the spacing between the AuSn layer elements 40 is preferably as small as possible.

Finally, referring to Fig. 16A and Fig. 16B which is a cross-sectional view taken along the line B-B in Fig. 16A, the LED element 1 of Figs. 14A and 14B is faced down in a thermal-pressuring process on the submount substrate 2 of Figs. 15A and 15B, so that the uppermost Au layers of the AuSn layer elements 40 of the AuSn layers 41 and 42 of the submount substrate 2 are eutectic with the uppermost Au layers of the p-side electrode 11 and the n-side electrode 12 of the LED element 1 to form AuSn eutectic bonding layers 41' and 42' each formed by multiple AuSn eutectic layer elements 40' . As a result, the p-side electrode 11 of the LED element 1 is electrically connected to the p-side wiring pattern layer 21 of the submount substrate 2, and the n-side electrode 12 of the LED element 1 is electrically connected to the n-side wiring pattern layer 22 of the submount substrate 2. Thus, the LED element 1 is bonded by the AuSn eutectic bonding layers 41' and 42' to the submount substrate 2, completing a semiconductor light emitting apparatus 4' .

Even in the semiconductor light emitting apparatus 4' of Figs. 16A and 16B, since the bonding defects of the AuSn eutectic bonding layers 41' and 42' can be dissolved, the fluctuation of the heat resistance and the fluctuation of the forward voltage can be improved, which would also improve the light emitting characteristics.

Also, since the burrs BR created on the edges of the AuSn layers 41 and 42 are small, or the AuSn layers 41 and 42 are not sloped lengthwise, shallowly concave or slightly convex, the AuSn eutectic bonding layer 41' -1, 41' -2, ···, 41' -6 and 42' after the thermal-pressuring process would hardly be protruded from the LED element 1. In addition, since the burrs BR of the AuSn layers 41-1, 41-2, ···, 41-6 and 42 are small, the LED element 1 would not be sloped. As a result, the LED element 1 would not be short-circuited to the wiring pattern layer 21 or 22 of the submount substrate 2, so that the semiconductor light emitting apparatus 4 would operate.

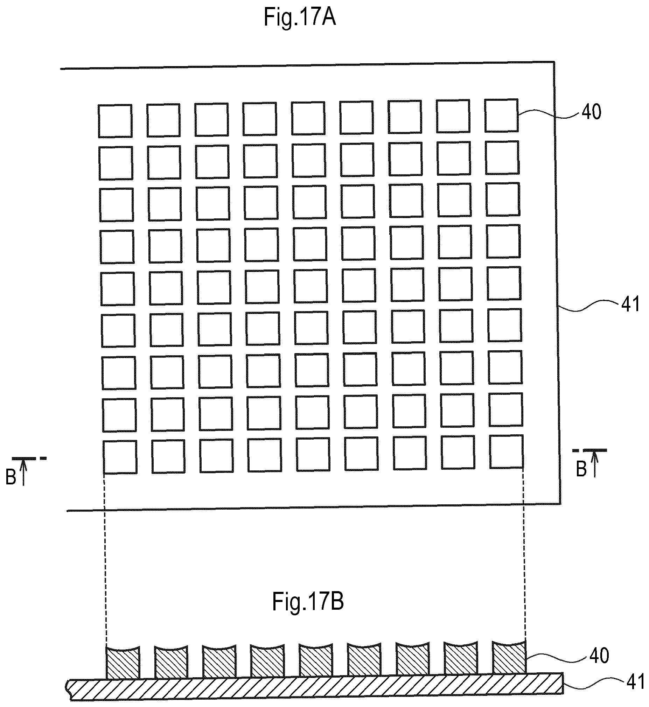

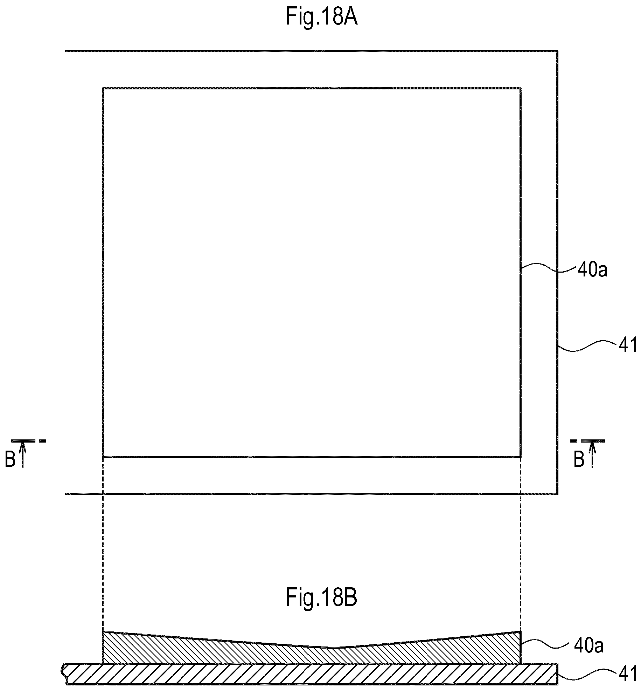

For example, as illustrated in Figs. 17A and 17B, each of the AuSn layer elements 40 is shallowly concave. Contrary to this, if the AuSn layer elements 40 are constructed by a single AuSn layer element 40a as illustrated in Figs. 18A and 18B, the single AuSn layer element 40a is greatly concave.

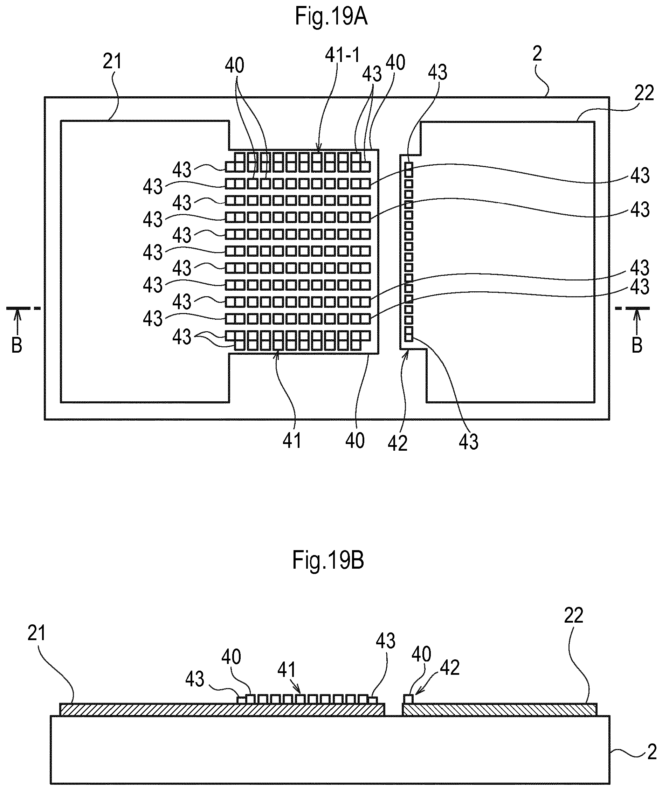

Fig. 19A is a top view illustrating a modification, in accordance with the present invention, of the submount substrate 2 of Figs. 15A and 15B, and Fig. 19B is a cross-sectional view taken along the line B-B in Fig. 19A.

In Figs. 19A and 19B, AuSn-phobic Cr layers 43 that lack an affinity to AuSn in order to repel AuSn are provided in contact with ends of the rows and columns of the AuSn layer elements 40. Therefore, in a thermal-pressuring process, the AuSn eutectic bonding layers 41' and 42' move away from the Cr layers 43, thus surely preventing the AuSn eutectic bonding layers 41' and 42' from protruding from the LED element 1 after the thermal-pressuring process.

The Cr layers 43 are formed before the formation of the AuSn layer elements 40 in the same way as in Figs. 13A, 13B and 13C.

In the above-described embodiments, the conductive bonding elements can be provided only between the p-side electrodes 11-1, 11-2, ···, 11-6 of the LED element 1 and the p-side wiring pattern layer 21 of the submount substrate 2, or the conductive bonding elements can be provided only between the n-side electrode 12 of the LED element 1 and the n-side wiring pattern layer 22 of the submount substrate 2.

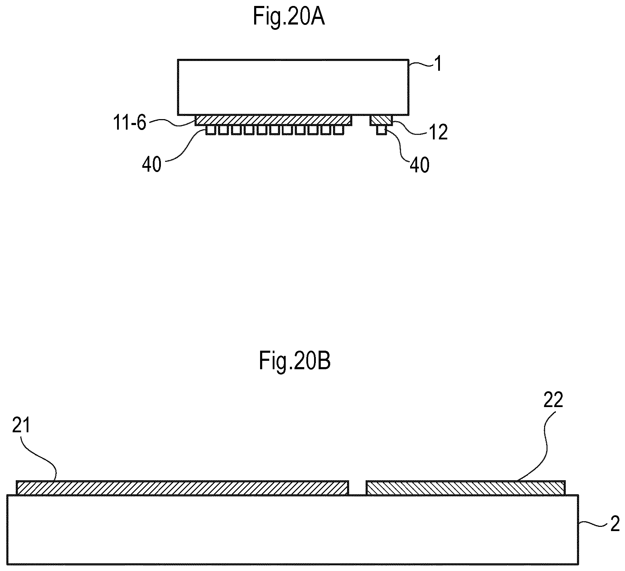

Also, in the above-described embodiments, the AuSn layer elements 40 are provided on the wiring pattern layers 21 and 22 of the submount substrate 2; however, as illustrated in Figs. 20A and 20B, the AuSn layer elements 40 can be provided on the p-side electrodes 11-1, 11-2, ···, 11-6 (or 11) and the n-side electrode 12 of the LED element 1. Also, the AuSn layer elements 40 can be formed by a screen printing process other than a lift-off process.

In addition, in the above-described embodiments of the present invention, the LED element 1 and the submount substrate 2 are bonded by AuSn eutectic bonding layer elements 40'. However, in alternative embodiments, not forming part of the present invention, the LED element 1 and the submount substrate 2 can be bonded by other conductive bonding elements such as Ag particle sintered elements or Au particle sintered elements. In this case, Ag-phobic layers that lack an affinity to repel Ag or Au-phobic layers that lack an affinity to repel Au can be used instead of the Cr layers 43.

Further, in other embodiments also not forming part of the present invention as claimed, the LED element 1 can be bonded directly to a conventional substrate without the submount substrate 2.

Still further, other semiconductor light emitting elements such as a laser diode (LD) element can be used instead of the LED element 1.

The semiconductor light emitting apparatus according to the presently disclosed subject matter can be applied to an ultra-violet light emitting apparatus, particularly, to a deep ultra-violet light emitting apparatus.

It will be apparent to those skilled in the art that various modifications and variations can be made in the presently disclosed subject matter without departing from the scope of the appended claims that define the present invention.

## Claims

1. A semiconductor light emitting apparatus comprising:
a semiconductor light emitting element (1) having a first electrode (11-1, 11-2, ..., 11-6, 11) and a second electrode (12);
a substrate (2) having first and second wiring pattern layers (21, 22) electrically-connected to said first and second electrodes (11-1, 11-2, ..., 11-6, 11; 12), respectively;
multiple AuSn eutectic bonding layer elements (40', 41', 42') provided between said first electrode (11-1, 11-2, ..., 11-6, 11) and said first wiring pattern layer (21) and/or between said second electrode (12) and said second wiring pattern layer (22); and
AuSn-phobic Cr layers (43), that lack an affinity to said multiple AuSn eutectic bonding layer elements (41'-1, 41'-2, ..., 41', 42') in order to repel said AuSn eutectic bonding layer elements (41'-1, 41'-2, ..., 41', 42'), in contact with ends of said multiple AuSn eutectic bonding layer elements (41'-1, 41'-2, ..., 41', 42').

2. The semiconductor light emitting apparatus as set forth in claim 1, wherein said multiple AuSn eutectic bonding layer elements (41'-1, 41'-2, ..., 41'-6, 41') are one-dimensionally or two-dimensionally arranged.

3. The semiconductor light emitting apparatus as set forth in claim 1, wherein said first electrode is defined as multiple first electrodes (11-1, 11-2, ..., 11-6),
said first and second electrodes (11-1, 11-2, ..., 11-6, 12) being rectangular viewed from the top, and each of said first and second electrodes (11-1, 11-2, ..., 11-6, 12) having a short side and a long side twice or more as long as said short side.

4. The semiconductor light emitting apparatus as set forth in claim 1, wherein said first electrode 2. (11-1, 11-2, ···, 11-6, 11) comprises a p-side electrode, and wherein said second electrode (12) comprises an n-side electrode.

5. A method for manufacturing a semiconductor light emitting apparatus comprising:
preparing a semiconductor light emitting element (1) having a first electrode (11-1, 11-2, ..., 11-6, 11) and a second electrode (12);
preparing a substrate (2) having first and second wiring pattern layers (21, 22) to be electrically-connected to said first and second electrodes (11-1, 11-2, ..., 11-6, 11; 12), respectively;
forming multiple AuSn eutectic bonding layer elements (40', 41', 42') using a lift-off process on one of said first electrode (11-1, 11-2, ..., 11-6, 11) and said first wiring pattern layer (21) and/or between said second electrode (12) and said second wiring pattern layer (22);
carrying out a thermal pressuring process to bond said first electrode (11-1, 11-2, ..., 11-6, 11) to said first wiring pattern layer (21) and bond said second electrode (12) to said second wiring pattern layer (22); and
forming AuSn-phobic Cr layers (43), that lack an affinity to said multiple AuSn eutectic bonding layer elements (41'-1, 41'-2, ..., 41', 42') in order to repel said AuSn eutectic bonding layer elements (41'-1, 41'-2, ..., 41', 42'), in contact with ends of said multiple AuSn eutectic bonding layer elements (41'-1, 41'-2, ..., 41', 42').

6. The method for manufacturing a semiconductor light emitting apparatus as set forth in claim 5, wherein said multiple AuSn eutectic bonding layer elements (41'-1, 41'-2, ..., 41'-6, 41') are one-dimensionally or two-dimensionally arranged.

7. The method for manufacturing a semiconductor light emitting apparatus as set forth in claim 5, wherein said first electrode (11) is defined as multiple first electrodes (11-1, 11-2, ..., 11-6),
said first and second electrodes (11-1, 11-2, ..., 11-6, 12) being rectangular viewed from the top, and each of said first and second electrodes (11-1, 11-2, ..., 11-6, 12) having a short side and a long side twice or more as long as said short side.

8. The method for manufacturing a semiconductor light emitting apparatus as set forth in claim 5, wherein said first electrode (11-1, 11-2, ..., 11-6, 11) comprises a p-side electrode, and wherein said second electrode (12) comprises an n-side electrode.

## Patentansprüche

1. Halbleiter-Lichtemissionsvorrichtung, umfassend:
ein Halbleiter-Lichtemissionselement (1) mit einer ersten Elektrode (11-1, 11-2, ..., 11-6, 11) und einer zweiten Elektrode (12);
ein Substrat (2) mit einer ersten und einer zweiten Verdrahtungsmusterschicht (21, 22), die jeweils elektrisch mit der ersten und der zweiten Elektrode (11-1, 11-2, ..., 11-6, 11; 12) verbunden sind;
mehrere AuSn-Eutektik-Verbindungs-Schichtelemente (40', 41', 42'), die zwischen der ersten Elektrode (11-1, 11-2, ..., 11-6, 11) und der ersten Verdrahtungsmusterschicht (21) und/oder zwischen der zweiten Elektrode (12) und der zweiten Verdrahtungsmusterschicht (22) vorgesehen sind; und
AuSn-abweisende Cr-Schichten (43), die keine Affinität zu den mehreren AuSn-Eutektik-Verbindungs-Schichtelementen (41'-1, 41'-2, ..., 41', 42') aufweisen, um die AuSn-Eutektik-Verbindungs-Schichtelemente (41'-1, 41'-2, ..., 41', 42') abzuweisen, wobei die AuSn-abweisenden Cr-Schichten (43) mit den Enden der mehreren AuSn-Eutektik-Verbindungs-Schichtelemente (41'-1, 41'-2, ..., 41', 42') in Kontakt stehen.

2. Halbleiter-Lichtemissionsvorrichtung nach Anspruch 1, wobei die mehreren AuSn-Eutektik-Verbindungs-Schichtelemente (41'-1, 41'-2, ..., 41'-6, 41') eindimensional oder zweidimensional angeordnet sind.

3. Halbleiter-Lichtemissionsvorrichtung nach Anspruch 1, wobei die erste Elektrode als mehrere erste Elektroden (11-1, 11-2, ..., 11-6) definiert ist,
wobei die ersten und zweiten Elektroden (11-1, 11-2, ..., 11-6, 12) von oben betrachtet rechteckig sind und jede der ersten und zweiten Elektroden (11-1, 11-2, ..., 11-6, 12) eine kurze Seite und eine lange Seite aufweist, die mindestens doppelt so lang ist wie die kurze Seite .

4. Halbleiter-Lichtemissionsvorrichtung nach Anspruch 1, wobei die erste Elektrode (11-1, 11-2, ..., 11-6, 11) eine p-seitige Elektrode umfasst und wobei die zweite Elektrode (12) eine n-seitige Elektrode umfasst.

5. Verfahren zur Herstellung einer Halbleiter-Lichtemissionsvorrichtung, umfassend:
Vorbereiten eines Halbleiter-Lichtemissionselements (1) mit einer ersten Elektrode (11-1, 11-2, ..., 11-6, 11) und einer zweiten Elektrode (12);
Herstellen eines Substrats (2) mit einer ersten und einer zweiten Verdrahtungsmusterschicht (21, 22), die jeweils mit der ersten und der zweiten Elektrode (11-1, 11-2, ..., 11-6, 11; 12) elektrisch verbunden werden sollen;
Bilden mehrerer AuSn-Eutektik-Verbindungs-Schichtelemente (40', 41', 42') unter Verwendung eines Lift-off-Verfahrens entweder auf der ersten Elektrode (11-1, 11-2, ..., 11-6, 11) oder auf der ersten Verdrahtungsmusterschicht (21) und/oder zwischen der zweiten Elektrode (12) und der zweiten Verdrahtungsmusterschicht (22);
Durchführen eines thermischen Pressverfahrens, um die erste Elektrode (11-1, 11-2, ..., 11-6, 11) mit der ersten Verdrahtungsmusterschicht (21) zu verbinden und die zweite Elektrode (12) mit der zweiten Verdrahtungsmusterschicht (22) zu verbinden; und
Bilden von AuSn-abweisenden Cr-Schichten (43), die keine Affinität zu den mehreren AuSn-Eutektik-Verbindungs-Schichtelementen (41'-1, 41'-2, ..., 41', 42') aufweisen, um die AuSn-Eutektik-Verbindungsschichtelemente (41'-1, 41'-2, ..., 41', 42') abzuweisen, wobei die AuSn-abweisenden Cr-Schichten (43) in Kontakt mit den Enden der mehreren AuSn-Eutektik-Verbindungs-Schichtelemente (41'-1, 41'-2, ..., 41', 42') stehen.

6. Verfahren zur Herstellung einer Halbleiter-Lichtemissionsvorrichtung nach Anspruch 5, wobei die mehreren AuSn-Eutektik-Bindeschichtelemente (41'-1, 41'-2, ..., 41'-6, 41') eindimensional oder zweidimensional angeordnet sind.

7. Verfahren zur Herstellung einer Halbleiter-Lichtemissionsvorrichtung nach Anspruch 5, wobei die erste Elektrode (11) als mehrere erste Elektroden (11-1, 11-2, ..., 11-6) definiert ist,
wobei die ersten und zweiten Elektroden (11-1, 11-2, ..., 11-6, 12) von oben betrachtet rechteckig sind und jede der ersten und zweiten Elektroden (11-1, 11-2, ..., 11-6, 12) eine kurze Seite und eine lange Seite aufweist, die mindestens doppelt so lang ist wie die kurze Seite.

8. Verfahren zur Herstellung einer Halbleiter-Lichtemissionsvorrichtung nach Anspruch 5, wobei die erste Elektrode (11-1, 11-2, ..., 11-6, 11) eine p-seitige Elektrode umfasst und wobei die zweite Elektrode (12) eine n-seitige Elektrode umfasst.

## Revendications

1. Dispositif semi-conducteur d'émission de lumière, comprenant :
un élément semi-conducteur d'émission de lumière (1) comportant une première électrode (11-1, 11-2, ..., 11-6, 11) et une deuxième électrode (12) ;
un substrat (2) comportant des première et deuxième couches de motifs de câblage (21, 22) connectées électriquement respectivement auxdites première et deuxième électrodes (11-1, 11-2, ..., 11-6, 11 ; 12) ;
plusieurs éléments de couche de liaison eutectique AuSn (40', 41', 42') prévus entre ladite première électrode (11-1, 11-2, ..., 11-6, 11) et ladite première couche de motif de câblage (21) et/ou entre ladite deuxième électrode (12) et ladite deuxième couche de motif de câblage (22) ; et
des couches de Cr (43) phobiques à l'AuSn, qui n'ont pas d'affinité avec lesdits multiples éléments de couche de liaison eutectique AuSn (41'-1, 41'-2, ..., 41', 42') afin de repousser lesdits éléments de couche de liaison eutectique AuSn (41'-1, 41'-2, ..., 41', 42'), en contact avec les extrémités desdits multiples éléments de couche de liaison eutectique AuSn (41'-1, 41'-2, ..., 41', 42').

2. Dispositif semi-conducteur d'émission de lumière selon la revendication 1, dans lequel lesdits multiples éléments de couche de liaison eutectique AuSn (41'-1, 41'-2, ..., 41'-6, 41') sont disposés de manière unidimensionnelle ou bidimensionnelle.

3. Dispositif semi-conducteur d'émission de lumière selon la revendication 1, dans lequel ladite première électrode est définie comme une pluralité de premières électrodes (11-1, 11-2, ..., 11-6),
lesdites première et deuxième électrodes (11-1, 11-2, ..., 11-6, 12) étant rectangulaires vues de dessus, et chacune desdites première et deuxième électrodes (11-1, 11-2, ..., 11-6, 12) ayant un petit côté et un grand côté deux fois plus long ou plus que ledit petit côté .

4. Dispositif semi-conducteur d'émission de lumière selon la revendication 1, dans lequel ladite première électrode (11-1, 11-2, ..., 11-6, 11) comprend une électrode de type p, et dans lequel ladite deuxième électrode (12) comprend une électrode de type n.

5. Procédé de fabrication d'un dispositif semi-conducteur d'émission de lumière, comprenant :
préparer un élément semi-conducteur émetteur de lumière (1) comportant une première électrode (11-1, 11-2, ..., 11-6, 11) et une deuxième électrode (12) ;
préparer un substrat (2) comportant des première et deuxième couches de motifs de câblage (21, 22) destinées à être connectées électriquement auxdites première et deuxième électrodes (11-1, 11-2, ..., 11-6, 11 ; 12), respectivement ;
former plusieurs éléments de couche de liaison eutectique AuSn (40', 41', 42') à l'aide d'un procédé de lift-off sur l'une desdites première électrode (11-1, 11-2, ..., 11-6, 11) et de ladite première couche de motif de câblage (21) et/ou entre ladite deuxième électrode (12) et ladite deuxième couche de motif de câblage (22) ;
réaliser un procédé de pressage thermique pour lier ladite première électrode (11-1, 11-2, ..., 11-6, 11) à ladite première couche de motif de câblage (21) e t lier ladite deuxième électrode (12) à ladite deuxième couche de motif de câblage (22) ; et
former des couches de Cr (43) phobiques à l'AuSn, qui n'ont pas d'affinité avec lesdits multiples éléments de couche de liaison eutectique AuSn (41'-1, 41'-2, ..., 41', 42') afin de repousser lesdits éléments de couche de liaison eutectique AuSn (41'-1, 41'-2, ..., 41', 42'), en contact avec les extrémités desdits multiples éléments de couche de liaison eutectique AuSn (41'-1, 41'-2, ..., 41', 42').

6. Procédé de fabrication d'un dispositif semi-conducteur d'émission de lumière selon la revendication 5, dans lequel lesdits multiples éléments de couche de liaison eutectique AuSn (41'-1, 41'-2, ..., 41'-6, 41') sont disposés de manière unidimensionnelle ou bidimensionnelle.

7. Procédé de fabrication d'un dispositif semi-conducteur d'émission de lumière selon la revendication 5, dans lequel ladite première électrode (11) est définie comme étant constituée de plusieurs premières électrodes (11-1, 11-2, ..., 11-6),
lesdites première et deuxième électrodes (11-1, 11-2, ..., 11-6, 12) étant rectangulaires vues de dessus, et chacune desdites première et deuxième électrodes (11-1, 11-2, ..., 11-6, 12) ayant un côté court et un côté long deux fois plus long ou plus que ledit côté court.

8. Procédé de fabrication d'un dispositif semi-conducteur d'émission de lumière selon la revendication 5, dans lequel ladite première électrode (11-1, 11-2, ..., 11-6, 11) comprend une électrode de type p, et dans lequel ladite deuxième électrode (12) comprend une électrode de type n.
